Europäisches Patentamt

European Patent Office

Office européen des brevets

(11) Publication number: **0 083 823**
**B1**

# EUROPEAN PATENT SPECIFICATION

(45) Date of publication of patent specification: **10.07.85**

(21) Application number: **82201671.3**

(22) Date of filing: **29.12.82**

(51) Int. Cl.⁴: **H 03 L 7/18,** H 03 J 7/06, G 01 R 23/10

(54) Frequency synthesizing circuit.

(30) Priority: **08.01.82 NL 8200050**

(43) Date of publication of application:
**20.07.83 Bulletin 83/29**

(45) Publication of the grant of the patent:
**10.07.85 Bulletin 85/28**

(84) Designated Contracting States:
**DE FR GB IT NL**

(56) References cited:
**DE-A-2 818 529**
**US-A-3 909 716**

(73) Proprietor: **N.V. Philips' Gloeilampenfabrieken**
**Groenewoudseweg 1**
**NL-5621 BA Eindhoven (NL)**

(72) Inventor: **Geurts, Martinus F. A. M.**
**c/o INT. OCTROOIBUREAU B.V. Prof. Holstlaan 6**
**NL-5656 AA Eindhoven (NL)**

(74) Representative: **Van Mal, Louis Johannes et al**
**INTERNATIONAAL OCTROOIBUREAU B.V.**
**Prof.Holstlaan 6**
**NL-5656 AA Eindhoven (NL)**

# Description

The invention relates to a frequency synthesizing circuit comprising an oscillator whose frequency is controllable by a control signal, a tuning data signal source, a digital difference-determining circuit for determining the digital value of the difference between the frequency determined by the tuning data signal source and the oscillator frequency and a digital-to-analog converter for converting the digital difference into the control signal, an input of the difference-determining circuit being coupled to an output of the oscillator at least *via* a gate circuit, a measuring pulse input of this gate circuit being coupled to an output of a pulse generator for applying a measuring pulse to the measuring pulse input.

A frequency synthesizing circuit of the above-described type is disclosed in Valvo Entwicklungsmitteilungen 70, November 1977, pages 33—35. It appears that with such a frequency synthesizing circuit the tuning of the oscillator deviates on an average to a small extent from the frequency desired by the tuning DATA signal source.

It is an object of the invention to obviate this disadvantage by means of a simple circuit.

According to the invention, a frequency synthesizing circuit of the type described in the opening paragraph is characterized in that the gate circuit incorporates a logic circuit for adding a pulse which is contiguous to an end of the measuring pulse to a signal applied by the gate circuit to the difference-determining circuit the edge of the added pulse which is contiguous to the measuring pulse being of a polarity not influencing the difference determining circuit, the added pulse having a duration such that the other edge has a predetermined position relative to an active period of the difference determined circuit which is independent of the phase relation between the measuring pulse and the oscillator output signal.

Using this measure it is prevented that at a changing phase shift of the measuring gate relative to the signal to be measured the difference-determining circuit observes sometimes a frequency deviation at a correct tuning of the oscillator, which causes the said average deviation of the oscillator tuning.

It has to be remarked that the US patent specification 3 909 716 describes a frequency measuring circuit in which a pulse signal, the frequency of which has to be measured, is gated to a counter by a gating circuit to which a measuring pulse is fed as a gating signal. In order to prevent the resulting counter output being dependent upon the phase relation between the pulse signal to be measured and the measuring pulse, the measuring pulse is synchronized to the pulse signal to be measured by shifting its edges so that they are always occurring between the pulses of the pulse signal to be measured. This however requires a very complicated edge shifting circuit.

The invention will now be described by way of example with reference to the accompanying drawing.

In the drawing:

Fig. 1 illustrates by means of a block schematic circuit diagram a receiver incorporating a frequency synthesizing circuit in accordance with the invention and

Fig. 2 illustrates by means of a number of waveforms the operation of the circuit shown in Fig. 1.

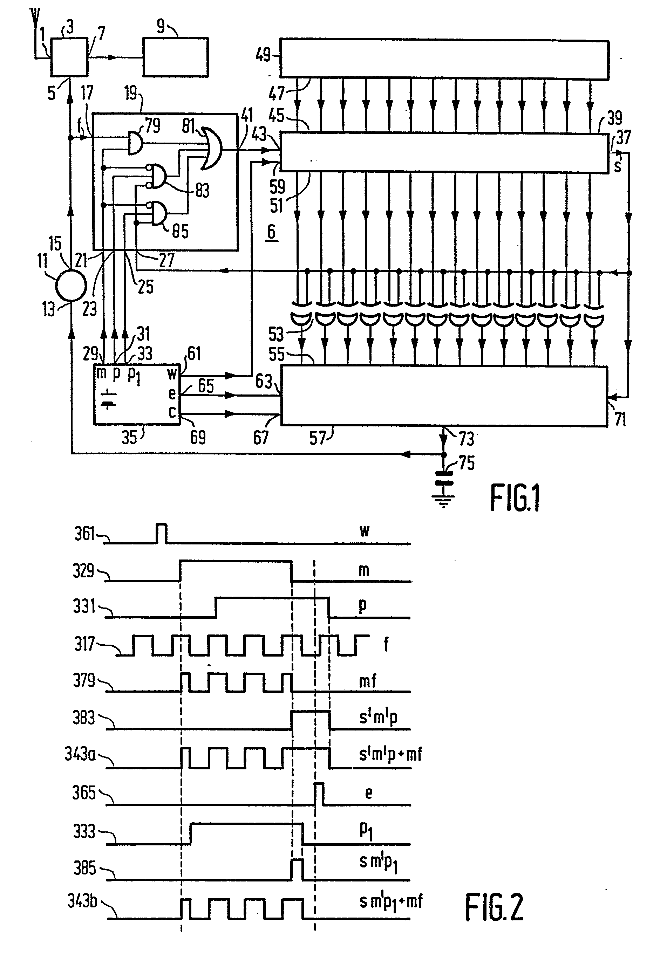

In Fig. 1, a received signal is applied to an input 1 of a high-frequency and mixing section 3. An input 5 of this high-frequency and mixing section 3 receives an oscillator signal from a frequency synthesizing circuit 6. In response thereto there appears at an output 7 of the high-frequency and mixing section 3 an intermediate frequency signal which is converted by an intermediate-frequency signal processing circuit 9 into a form of display or reproduction, for example, picture display or sound reproduction.

The frequency synthesizing circuit 6 comprises an oscillator 11, whose frequency is controllable by a control signal to be applied to a control signal input 13. An output 15 of the oscillator 11 is connected to the input 5 of the high-frequency and mixing section 3 and to an input 17 of a gate circuit 19. For the sake of clarity, frequency dividers, amplifiers or limiters which may be arranged before the input 17 of the gate circuit 19 are not shown.

A signal *f* which is shown by means of the waveform 317 in Fig. 2 is applied to the input 17 of the gate circuit 19.

An input 21 and an input 23, 25, 27, respectively of the gate circuit 19 are connected to an output 29 and to respective outputs 31, 33 of a pulse signal generator 35 and to an output 37, respectively of a difference-determining circuit 39. The input 21 and the respective inputs 23, 25 of the gate circuit 19 receive a measuring pulse *m* and a pulse *p*, respectively and a pulse $p_1$ from the respective outputs 29, 31, 33 of the pulse signal generator 35. In Fig. 2 these signals are shown by means of the waveforms 329, 331, 333, respectively. The input 17 of the gate circuit 19 receives a sign signal *s* from the output 37 of the difference-determining circuit 39.

An output 41 of the gate circuit 19 is connected to an input 43 of the difference-determining circuit 39, which as a result thereof receives a signal having a waveform 343a or 343b shown in Fig. 2.

The difference-determining circuit 39 has an input combination 45 which is connected to an output combination 47 of a tuning data signal source 49 and an output combination 51, each input of which is connected to an input of an input combination 55 of a modulation circuit 57 *via* an exclusive-OR-gate of an exclusive-OR-gate circuit 53. The further inputs of the exclusive-OR-gates 53 are connected to the sign signal output 37 of the difference-determining circuit 39. A write signal input 59 of the difference-determining circuit 39 receives a write signal $w$ from an output 61 of pulse signal generator 35. This signal $w$ is shown in Fig. 2 by means of the waveform 361.

The modulation circuit 57 further has an input 63 to which a read signal $e$ obtained from an output 65 of the pulse generator 35 is applied and which is shown in Fig. 2 by means of the waveform 365. A clock signal input 67 of the modulation circuit 57 receives a clock signal, which is not shown in Fig. 2 from an output of the pulse generator 35. Also the sign signal $s$ which is applied to an input 71 of the modulation circuit 57 is not shown in Fig. 2.

A capacitor 75 and the control signal input 13 of the oscillator are connected to an output 73 of the modulation circuit 57. Together with the modulation circuit 57 the capacitor 75 forms a digital-to-analog converter.

The gate circuit 19 incorporates an AND-gate 79 which is connected to the inputs 17 and 21 and which applies an output signal $mf$ which is denoted in Fig. 2 by 379 to an OR-gate 81, to an AND-gate 83, an input of which is connected to the input 23 and inverting inputs to the inputs 21 and 27 and which applies an output signal $s'm'p$ denoted in Fig. 2 by 383 to the OR-gate 81, and to an AND-gate 85 an inverting input of which is connected to the input 21 and two other inputs are connected to the respective inputs 25 and 27 and which applies to the OR-gate 81 an output signal $sm'p_1$ denoted in Fig. 2 by 385.

Waveforms shown in Fig. 2 are not represented on the correct scale and occur periodically.

The frequency synthesizing circuit 6 operates as follows.

In response to the write signal $w$ at the input 59 of the difference-determining circuit 39 this counter assumes a position which corresponds to a binary number supplied by the tuning data signal source 49 and its output combination 47, which binary number represents the desired tuning frequency of the oscillator 11.

Thereafter, at each negative edge occurring at the input 43, the position of the counter, which will be denoted measuring counter hereinafter, of the difference-determining circuit decreases by one.

As long as the measuring counter does not pass through its zero position the signal $s$ at the output 37 is zero and the exclusive-OR gates convey the position of the measuring counter occurring at the output combination 51 to the input combination 55 of the modulation circuit 57. If the measuring counter passes through its zero position, then the sign signal $s$ becomes one and the exclusive-OR-gates 53 invert the measuring counter position which was conveyed to the input combination 55 of the modulation circuit 57.

The modulation circuit 57 incorporates a modulation counter which at the instant of occurrence of the read signal $e$ at the input 63 takes over the position of the measuring counter of the difference-determining circuit 39 conveyed by the exclusive-OR-gates 53 is transferred and thereafter, in response to the clock pulses $c$ at the input 67, the modulation counter counts to zero and then stops. As a result thereof there is produced at an output 73 of the modulation circuit 57 a current pulse whose duration depends on the position of the measuring counter occurring at the instant of occurrence of the signal $e$ and on the direction of the sign signal $s$ of the difference-determining circuit 39. These periodically occurring pulses charge or discharge the capacitor 75, which applies the control signal to the oscillator 11 as a result of which the number of negative edges occurring between the write signal $w$ and the read signal $e$ at an output 43 of the difference-determining circuit 39 corresponds to the number supplied by the tuning data signal source 49.

This number of negative edges is determined by the gate circuit 19.

If the signal at the output 41 of the gate circuit 19 were only produced, as has been customary so far, by the AND-gate 79, then at a number $n$ for which, for the sake of clarity, three is chosen here, $n$ so in this case three, periods of the signal must be included in the measuring pulse period of the measuring pulse $m$. In these three periods the number of negative edges can be three or four, depending on the phase relationship between the measuring pulse $m$ and the signal $f$ to be measured. This phase may vary continuously, as the phase of the pulse generator 35 is not coupled to the phase of the signal $f$ to be measured. In response to the operation of the frequency synthesizing circuit the frequency of the signal $f$ will now be controlled such that half the period of time it is

$$\frac{n+1}{T},$$

wherein T is the period of time in which the measuring pulse $m$ occurs, and half the period of time it is

$$\frac{n}{T}$$

so that the average frequency deviates by

$$\frac{1}{2} \cdot \frac{1}{T}$$

from the desired value.

In order to obviate this unwanted phenomenon the AND-gate 83 now adds an additional pulse $s'm'p$ to the signal $mf$ via the OR-gate 81 when the sign signal $s$ is zero. This additional pulse is contiguous to the trailing edge of the measuring pulse $m$ and continuous after the occurrence of the read signal $e$ so that now, independent of the phase relationship, always three and so generally

$n$ negative edges occur between the write signal $w$ and the read signal $e$, if the measuring period is $n$-times the period of the signal $f$. This is shown by the waveform 343a of Fig. 2.

When it passes through zero, the measuring counter of the difference-determining circuit 39 causes the sign signal $s$ at its output 37 to change from zero to one. As a result thereof the exclusive-OR-gate combination 53 supplies a combination having the value, zero, both at the zero position and at the minus-one position of the measuring counter.

The AND-gate 85 ensures that at negative values of the counting position of the measuring counter one edge more is counted because of the fact that the added pulse $sm'p_1$ becomes zero, so that the output signal of the gate circuit 19 now gets in accordance with the waveform 343b of Fig. 2 an additional negative edge at the occurrence of the write signal $w$ and the read signal $e$, so that the occurrence twice consecutively of a zero value at the input combination 55 is prevented from occurring and also negative values of the measuring counting positions are converted into an absolute value by the exclusive-OR-gates 53.

It will be obvious that this last measure is not required when an up-down counter is employed in the difference-determining circuit 39.

It will further be obvious that if so desired the same result can be accomplished by adding an additional pulse which is contiguous to the leading edge of the measuring pulse $m$, and by the adequate choice of the location of the leading edge thereof relative to the write signal $w$ if the measuring counter of the difference-determining circuit 39 counts positive edges.

It will further be obvious that, if so desired instead of shifting the relevant edge of the additional pulse by means of the sign signal $s$ the positions of the read signal $e$ or of the write signal $w$ may be shifted when a measuring counter counting positive edges is used.

The frequency synthesizing circuit 6 is here described as forming part of a receiver. It may, of course, form part if so desired of, for example, a transmitter or a measuring instrument.

If so desired other gate combinations in the gate circuit can be used to obtain corresponding logic functions.

The signals $p$ and $p_1$ may be delayed measuring pulses or may be obtained in a different manner.

**Claims**

1. A frequency synthesizing circuit comprising an oscillator (11) whose frequency is controllable by a control signal, a tuning data signal source (49), a digital difference-determining circuit (39) for determining the digital value of the difference between the frequency determined by the tuning data signal source and the oscillator frequency and a digital-to-analog converter (57, 75), for converting the digital difference into the control signal, an input (43) of the difference-determining circuit being coupled at least via a gate circuit (19) to an output (15) of the oscillator, a measuring pulse input (21) of this gate circuit being coupled to an output (29) of a pulse generator (35) for applying a measuring pulse ($m$) to the measuring pulse input, characterized in that the gate circuit (19) incorporates a logic circuit (81, 83) for adding a pulse which is contiguous to an end of the measuring pulse ($m$) to a signal applied by the gate circuit (19) to the input (43) of the difference-determining circuit (39) the edge of the added pulse which is contiguous to the measuring pulse being of a polarity not influencing the difference determining circuit, the added pulse having a duration such that the other edge has a predetermined position relative to an active period ($w$-$e$) of the difference determining circuit which is independent of the phase relation between the measuring pulse ($m$) and the oscillator output signal ($f$).

2. A frequency synthesizing circuit as claimed in Claim 1, characterized in that the difference-determining circuit (39) incorporates a one-way counter whose outputs (51) are coupled to the digital-to-analog converter (57, 75) via exclusive-OR-gates (53) and a sign signal output (37) of which is coupled to the further inputs of the exclusive-OR-gates (53) and to a circuit (83, 85) for changing-over the relative positions of an end of the pulse to be added and a write or read signal of the difference-determining circuit.

3. A frequency synthesizing circuit as claimed in Claim 2, the pulse to be added being contiguous to the trailing edge of the measuring pulse, characterized in that the gate circuit (19) incorporates a logic circuit (83, 85) for changing over the duration of the pulse to be added.

4. A frequency synthesizing circuit as claimed in Claim 3, characterized in that the gate circuit (19) has a gate function (79, 81, 83, 85) corresponding to the logic formula

$$s'm'p + sm'p_1 + mf$$

wherein $s$ is the sign signal, $f$ the signal whose frequency must be measured, $p$ a pulse having a leading edge occurring before the end of the measuring pulse $m$ and a trailing edge occurring after the instant of occurrence of the read signal $e$ of the difference-determining circuit (39), and $p_1$ a pulse having a leading edge occurring before the end of the measuring pulse $m$ and a trailing edge occurring before the instant of occurrence of the read signal $e$ of the difference-determining circuit.

**Patentansprüche**

1. Frequenzsynthese-Schaltung mit einem von einem Regelsignal frequenzregelbaren Oszillator (11), mit einer Abstimmdatensignalquelle (49), mit einer digitalen Differenzbestimmungsschaltung (39) für die Bestimmung des digitalen Wertes des Unterschieds zwischen der von der Abstimmdatenquelle bestimmten Frequenz und der Oszillatorfrequenz und mit einem Digital/Analog-Wandler (57, 75) zum Umsetzen des digitalen Unterschieds in das Regelsignal, wobei ein Eingang (43) der Differenzbestimmungsschaltung zumindest über eine Gatterschaltung (19) an einem Ausgang (15) des Oszillators angeschlossen ist, wobei ein Messimpulseingang (21) dieser Gatterschaltung mit einem Ausgang (29) eines Impulsgebers (35) zum Anlegen eines Messimpulses (m) an den Messimpulseingang verbunden ist, dadurch gekennzeichnet, dass die Gatterschaltung (19) eine Logikschaltung (81, 83) enthält, die einen Impuls beimischt, der sich an ein Ende des Messimpulses (m) zu einem von der Gatterschaltung (19) dem Eingang (43) der Differenzbestimmungsschaltung (39) zugeführten Signal anschliesst, wobei die Flanke des beigemischten Impulsen, die sich an den Messimpuls anschliesst, eine die Differenzbestimmungsschaltung nicht beeinflussende Polarität hat, und der beigemischte Impuls eine derartige Dauer hat, dass die andere Flanke eine in bezug auf eine aktive Periode (w-e) der Differenzbestimmungsschaltung vorgegebene Lage hat, die vom Phasenverhältnis zwischen dem Messimpuls (m) und dem Oszillatorausgangssignal (f) unabhängig ist.

2. Frequenzsynthese-Schaltung nach Anspruch 1, dadurch gekennzeichnet, dass die Differenzbestimmungsschaltung (39) einen Einwegzähler enthält, dessen Ausgänge (51) über Exklusiv-ODER-Gatter (53) mit dem Digital/Analog-Wandler (57, 75) verbunden sind und von dem ein Vorzeichensignalausgang (37) mit den weiteren Eingängen der Exklusiv-ODER-Gatter (53) und mit einer Schaltung (83, 85) zum Umschalten der relativen Lagen eines Endes des beizumischenden Impulses und eines Schreib- oder Lesesignals der Differenzbestimmungsschaltung verbunden ist.

3. Frequenzsynthese-Schaltung nach Anspruch 2, wobei sich der beizumischende Impuls an die Rückflanke des Messimpulses anschliesst, dadurch gekennzeichnet, dass die Gatterschaltung (19) eine Logikschaltung (83, 85) zum Umschalten der Dauer des beizumischenden Impulses enthält.

4. Frequenzsynthese-Schaltung nach Anspruch 3, dadurch gekennzeichnet, dass die Gatterschaltung (19) eine der logischen Formel

$$s'm'p+sm'p_1+mf$$

entsprechende Gatterfunktion (79, 81, 83, 85) hat, worin $s$ das Vorzeichensignal, $f$ das Signal, dessen Frequenz zu messen ist, $p$ ein Impuls mit einer vor dem Ende des Messimpulses $m$ auftretenden Vorderflanke und einer nach dem Zeitpunkt des Auftretens des Lesesignals $e$ der Differenzbestimmungsschaltung (39) auftretenden Rückflanke, und $p_1$ ein Impuls mit einer vor dem Ende des Messimpulses $m$ auftretenden Vorderflanke und einer vor dem Zeitpunkt des Auftretens des Lesesignals $e$ der Differenzbestimmungsschaltung auftretenden Rückflanke ist.

## Revendications

1. Circuit de synthèse de fréquence comprenant un oscillateur (11) dont la fréquence peut être commandée par un signal de commande, une source de signal de données d'accords (49), un circuit de détermination de différence numérique (39) pour déterminer la valeur numérique de la différence entre d'une part la fréquence déterminée par ladite source de signal de données d'accord et d'autre part la fréquence d'oscillateur, ainsi qu'un convertisseur numérique-analogique (57, 75) pour convertir ladite différence numérique en signal de commande, une entrée (43) du circuit de détermination de différence étant couplée à une sortie (15) de l'oscillateur au moins à travers un circuit-porte (19) dont une entrée d'impulsion de mesure (21) est couplée à une sortie (29) d'un générateur d'impulsions (35) pour appliquer une impulsion de mesure $m$ à l'entrée d'impulsion de mesure, caractérisée en ce que le circuit-porte (19) comporte un circuit logique (81, 83) pour additionner une impulsion, contiguë à une extrémité de l'impulsion de mesure (m) à un signal appliqué à l'entrée (43) du circuit de détermination de différence (39) par le circuit-porte (19), la polarité du flanc de l'impulsion additionnée, contiguë à l'impulsion de mesure, étant telle qu'elle n'influence pas le circuit de détermination de différence, alors que la durée de l'impulsion additionnée est telle que l'autre flanc occupe, par rapport à la période active (w-e) du circuit de détermination de différence, une position prédéterminée qui est indépendante de la relation de phase entre l'impulsion de mesure (m) et le signal de sortie d'oscillateur (f).

2. Circuit de synthèse de fréquence selon la revendication 1, caractérisé en ce que le circuit de détermination de différence (39) comporte un compteur qui ne compte que progressivement ou régressivement et dont les sorties (51) sont couplées au convertisseur numérique-analogique (57, 75) à travers des portes-OU EXCLUSIF (53), une sortie de signal de signe (37) dudit compteur étant couplée aux autres entrées des portes-OU EXCLUSIF (53) ainsi qu'à un circuit (83, 85) pour interchanger les positions relatives d'une extrémité de l'impulsion à additionner et d'un signal d'inscription ou de lecture du circuit de détermination de différence.

3. Circuit de synthèse de fréquence selon la revendication 2, l'impulsion à additionner étant contiguë au flanc arrière de l'impulsion de mesure, caractérisé en ce que le circuit-porte (19) comporte un circuit logique (83, 85) pour changer la durée de l'impulsion à additionner.

4. Circuit de synthèse de fréquence selon la revendication 3, caractérisé en ce que le circuit-porte (19) a une fonction de porte (portes 79, 81, 83, 85) correspondant à la formule logique

$$s'm'p+sm'p_1+mf$$

dans laquelle $s$ indique le signal de signe, $f$

indique le signal dont il y a lieu de mesurer la fréquence, $p$ indique une impulsion ayant un flanc avant survenant avant la fin de l'impulsion de mesure $m$ et un flanc arrière survenant après l'instant où survient le signal de lecture $e$ du circuit de détermination de différence (39), alors

que $p_1$ indique une impulsion ayant un flanc avant survenant avant la fin de l'impulsion de mesure $m$ et un flanc arrière survenant avant l'instant où survient le signal de lecture $e$ du circuit de détermination de fréquence (39).

FIG.1

FIG.2